(19) **Europäisches Patentamt**

**European Patent Office**

**Office européen des brevets**

(11) **EP 1 340 838 A1**

(12) **EUROPEAN PATENT APPLICATION**
published in accordance with Art. 158(3) EPC

(43) Date of publication:
03.09.2003 Bulletin 2003/36

(51) Int Cl.⁷: **C23C 16/54**, H01L 21/205, H01L 21/31, H01L 21/302

(21) Application number: 01996640.7

(22) Date of filing: 14.11.2001

(86) International application number:
PCT/JP01/09941

(87) International publication number:
WO 02/040742 (23.05.2002 Gazette 2002/21)

(84) Designated Contracting States:
AT BE CH CY DE DK ES FI FR GB GR IE IT LI LU MC NL PT SE TR

(30) Priority: 14.11.2000 JP 2000346859
14.11.2000 JP 2000346861

(71) Applicant: SEKISUI CHEMICAL CO., LTD.
Osaka-shi, Osaka 530-8565 (JP)

(72) Inventors:
• YARA, Takuya, Sekisui Chemical Co., Ltd.
Mishima-gun, Osaka 618-8589 (JP)

• YUASA, Motokazu, Sekisui Chemical Co., Ltd.
Mishima-gun, Osaka 618-8599 (JP)
• HOMMA, Koji, Chemitronics Co., Ltd.
Tokyo 207-0021 (JP)
• KOZUMA, Makoto, Sekisui Chemical Co., Ltd.
Tokyo 192-0906 (JP)

(74) Representative: Moinas, Michel et al
Cabinet Michel Moinas
13 Chemin du Levant
01210 Ferney-Voltaire (FR)

(54) **METHOD AND DEVICE FOR ATMOSPHERIC PLASMA PROCESSING**

(57)　　A method and a device for aunospheric plasma processins: the method capable of processing a processed body, comprising the stops ol; under a pressure near the atmospheric pressurc, installing a fixed dielectric on the opposed surface ol'at least one of a pair of electrodes opposed to each other. Icading processing cas between die pair of opposed electrodes, and applying a lield between the electrodes to provide plasma, and allowin_ die plasma to come into contact with the processed body, characterized in that the processed cas is exhausted from near a processed part l'or allowing the plasma to coure into contact with the processed body, and the arca near the processed part is hcld in a specified sas atmosphere by a sas atmosphere conditioning mechanism.

Figure 5

(a)

**Description**

BACKGROUND OF THE INVENTION

FIELD OF THE INVENTION

The present invention relates to a method for plasma treatment under the atmospheric pressure and an equipment therefor having a gas atmosphere control mechanism, whereby an used gas of the treatment is exhausted from the vicinity of treatment section, and the vicinity of treatment section is maintained under a specified gas atmosphere.

DESCRIPTION OF THE PRIOR ART

Conventionally, such a method has practically been used that a modification of or a thin film formation onto the surface of an article to be treated is performed by generating a glow discharge plasma under a condition of reduced pressure. However, since the treatment under the condition of reduced pressure needs facilities such as a vacuum chamber and a vacuum exhausting equipment, a complicated treatment procedure, as well as an expensive surface treatment equipment, it has scarcely been used when a substrate having a large area is treated. Therefore, a method for generating a discharge plasma under a pressure near the atmospheric pressure has been proposed.

Conventional methods for the plasma treatment under the atmospheric pressure include a method for treatment under a helium atmosphere as disclosed in JP-A-2-48626 and another method for treatment under an argon and acetone and/or helium atmosphere as disclosed in JP-A-4-74525. In any of the above-described methods, however, plasma is generated under a gas atmosphere containing organic compounds such as acetone or helium, and thus the gas atmosphere is limited. Further, helium is disadvantageous for an industrial use because of an expensive cost thereof. If the gas containing an organic compound is used, the organic compound itself often reacts with the article to be treated and a desired surface treatment cannot necessarily be obtained.

In addition, in a film formation in producing a semiconductor element or the like, the conventional method for plasma treatment under the atmospheric pressure is disadvantageous for an industrial process because of a slow treatment speed thereof. Further, in treatments such as thin film formation at a high temperature and dry etching, there has been a problem that an oxidation of the article to be treated, a film formed, an etched part or the like may occur depending on the gas atmosphere in the vicinity of treatment section where plasma and the article to be treated are in contact, resulting in impairing to obtain a good quality of semiconductor element. Even if a treatment is conducted in a closed chamber after evacuated to solve these problems described above, the treatment cannot be applied to a high speed treatment or a treatment for a substrate having a large area as in the treatment under the reduced pressure. This is the present situation.

SUMMARY OF THE INVENTION

In view of the above-described problems, an object of the present invention is to provide a method for plasma treatment under the atmospheric pressure and an equipment therefor, which can be applied to the high speed treatment or the treatment for a large area.

The present inventors, after extensively studied to solve the above-described problems, found that a method enabling the high speed treatment and the large area treatment and also suppressing a deterioration of a thin film formed on a substrate or a cut face of substrate due to etching treatment or the like became possible, by combining the method for plasma treatment under the atmospheric pressure which could realize a stable discharge state under the condition of atmospheric pressure before/after the treatment with a gas atmosphere control mechanism, and accomplished the present invention.

The first aspect of the present invention provides a method for plasma treatment under the atmospheric pressure for treating the article to be treated comprising: providing a solid dielectric on at least one opposing face of a pair of opposing electrodes under a pressure near the atmospheric pressure; introducing a treatment gas between said a pair of opposing electrodes; generating plasma by applying an electric field between said electrodes; and contacting the plasma with the article to be treated, wherein an used gas is exhausted from the vicinity of treatment section where said plasma and the article to be treated are in contact, and said vicinity of treatment section is maintained under a specified gas atmosphere by a gas atmosphere control mechanism.

The second aspect of the present invention provides the method for plasma treatment under the atmospheric pressure according to the first invention, wherein said exhaustion of the used gas from the vicinity of treatment section is performed by a gas passage control mechanism composed of a passage for plasma gas blown out, a passage to an exhaust gas exit and a sealed space substantially preventing a gas flow to the vicinity of treatment section.

The third aspect of the present invention provides the method for plasma treatment under the atmospheric pressure according to the first invention, wherein said exhaustion of the used gas from the vicinity of treatment section is performed by an exhaustion mechanism which exhausts the used gas from the back side of a support for the article to be treated.

The fourth aspect of the present invention provides the method for plasma treatment under the atmospheric pressure according to one of the inventions 1 to 3, wherein said gas atmosphere controlmechanism is a mechanism whereby the vicinity of treatment section, where plasma and the article to be treated are in contact, is maintained under the specified gas atmosphere by a gas curtain mechanism.

The fifth aspect of the present invention provides the method for plasma treatment under the atmospheric pressure according to one of the inventions 1 to 4, wherein the vicinity of treatment section, where plasma and the article to be treated are in contact, is maintained under the specified gas atmosphere by providing an exhaust gas exit in the periphery of the vicinity of treatment section where the plasma and the article to be treated are in contact, and also the gas curtain mechanism in the periphery of the exhaust gas exit.

The sixth aspect of the present invention provides the method for plasma treatment under the atmospheric pressure according to the first invention, wherein, in the plasma treatment using a remote source having an extended length of nozzle equipped in crosswise direction of said article to be treated, an exhaust gas exit is provided in crosswise direction of the treatment section where said plasma and said article to be treated are in contact, and a side seal mechanism is provided in the lengthwise direction of said treatment section.

The seventh aspect of the present invention provides the method for plasma treatment under the atmospheric pressure according to the first invention, wherein the vicinity of treatment section, where plasma and the article to be treated are in contact, is maintained under the specified gas atmosphere by conducting the treatment in a vessel through which the specified gas flows.

The eighth aspect of the present invention provides the method for plasma treatment under the atmospheric pressure according to the first invention, wherein at least two chambers composed of chamber 1 enclosing the discharge plasma generation section and the article to be treated and chamber 2 enclosing the chamber 1 are provided, and those chambers are designed so that a gas flows out from the chamber 1 and the external air flows into the chamber 2 by making the pressure in said chamber 2 lower than the pressure in the chamber 1, and also lower than the external atmospheric pressure.

The ninth aspect of the present invention provides the method for plasma treatment under the atmospheric pressure according to one of the inventions 1 to 8, wherein the specified gas atmosphere comprises at least one kind of gas selected from the group consisting of nitrogen, argon, helium, neon, xenon and dry air.

The tenth aspect of the present invention provides the method for plasma treatment under the atmospheric pressure according to one of the inventions 1 to 8, wherein the electric field applied between the electrodes is a pulse-like electric field having a pulse rise time and/or a pulse decay time of not longer than 10 $\mu$s and a field strength of 10 to 1,000 kV/cm.

The eleventh aspect of the present invention provides an equipment for plasma treatment under the atmospheric pressure comprising: a pair of opposing electrodes with a solid dielectric being provided on at least one opposing face thereof; a mechanism for introducing a treatment gas between said a pair of opposing electrodes; a mechanism for applying an electric field between said electrodes; a mechanism for contacting plasma obtained by said electric field with the article to be treated; a mechanism for exhausting an used gas; and a mechanism for maintaining the vicinity of treatment section, where said plasma and the article to be treated are in contact, under a specified gas atmosphere.

The twelfth aspect of the present invention provides the equipment for plasma treatment under the atmospheric pressure according to the eleventh invention, wherein the mechanism for exhausting the used gas from the vicinity of treatment section is a gas passage control mechanism composed of a passage for plasma gas blown out, a passage to an exhaust gas exit and a sealed space substantially preventing a gas flow to the vicinity of treatment section.

The thirteenth aspect of the present invention provides the equipment for plasma treatment under the atmospheric pressure according to the eleventh invention, wherein the mechanism for maintaining the vicinity of treatment section, where plasma and the article to be treated are in contact, under the specified gas atmosphere is a gas curtain mechanism.

The fourteenth aspect of the present invention provides the equipment for plasma treatment under the atmospheric pressure according to one of the inventions 11 to 13, wherein the vicinity of treatment section, where plasma and the article to be treated are in contact, is maintained under the specified gas atmosphere, by providing the mechanism for exhausting an used gas in the periphery of treatment section, where plasma and the article to be treated are in contact, and the gas curtain mechanism in the periphery of the mechanism for exhausting an used gas.

The fifteenth aspect of the present invention provides the equipment for plasma treatment under the atmospheric pressure according to the eleventh invention, wherein the vicinity of treatment section, where plasma and the article to be treated are in contact, is maintained under the specified gas atmosphere, by conducting the treatment in a vessel through which a specified gas flows.

The sixteenth aspect of the present invention provides the equipment for plasma treatment under the atmospheric pressure according to the eleventh invention, wherein at least two chambers composed of chamber 1 enclosing a discharge plasma generation section and the article to be treated and chamber 2 enclosing the chamber 1 are provided, and those chambers are designed so that a gas flows out from the chamber 1 and the external air flows into the chamber 2 by making the pressure in said chamber 2 lower than the pressure in the chamber 1, and also lower than the external atmospheric pressure.

BRIEF DESCRIPTION OF THE DRAWINGS

Figure 1 shows examples of voltage wave forms of pulse electric field used in the present invention.

Figure 2 shows an example of equipment for plasma treatment under the atmospheric pressure.

Figure 3 shows an example of equipment for plasma treatment under the atmospheric pressure.

Figure 4 shows an example of equipment for plasma treatment under the atmospheric pressure.

Figure 5 shows an example of equipment for plasma treatment under the atmospheric pressure according to the present invention.

Figure 6 shows drawings illustrating principle of the equipment shown in Figure 5.

Figure 7 shows an example of equipment for plasma treatment under the atmospheric pressure according to the present invention.

Figure 8 shows an example of equipment for plasma treatment under the atmospheric pressure according to the present invention.

Figure 9 shows an example of equipment for plasma treatment under the atmospheric pressure according to the present invention.

Figure 10 shows an example of equipment for plasma treatment under the atmospheric pressure according to the present invention.

Figure 11 shows an example of equipment for plasma treatment under the atmospheric pressure according to the present invention.

Figure 12 is examples of bottom views of devices for a specified gas shower function used in the present invention.

Figure 13 shows an example of equipment for plasma treatment under the atmospheric pressure according to the present invention.

Figure 14 shows an example of equipment for plasma treatment under the atmospheric pressure according to the present invention.

Figure 15 shows an example of equipment for plasma treatment under the atmospheric pressure according to the present invention.

Figure 16 shows an example of equipment for plasma treatment under the atmospheric pressure according to the present invention.

NOTATION

| 1: | Power source (high voltage pulse power source) |
| 2,3: | Electrode |
| 4: | Discharge space |
| 5: | Treatment gas inlet |
| 6: | Gas blow opening |
| 7: | Nozzle |
| 8: | Solid dielectric |
| 10: | Exhaust gas exit |
| 11: | Specified gas inlet |
| 12: | Exhaust gas exit |
| 14: | Article to be treated |
| 15: | Support |
| 16: | Side seal |
| 17: | Robot |
| 20: | Chamber |
| 21,31: | Pressure gauge |
| 30: | Vessel (Chamber) |
| 32: | Rectifier plate |
| 35: | Opening |
| 111: | Pore |
| 121: | Pressure control valve |
| 141-142: | Micro-article to be treated |
| 161: | Baffle |
| 162: | Expansion room |
| 311: | Carrying in/out room |
| 312: | Cassette |
| 313: | Shutter |

DETAILED DESCRIPTION OF THE INVENTION

A method for plasma treatment under the atmospheric pressure of the present invention and an equipment therefor are a method and an equipment comprising: providing a solid dielectric on at least One opposing face of a pair of opposing electrodes under a pressure near the atmospheric pressure; introducing a treatment gas between the pair of opposing electrodes; applying an electric field between the electrodes; and contacting a glow discharge plasma of the treatment gas obtained with an article to be treated, wherein the article to be treated or a thin film formed on the article to be treated is protected as well as contamination of the surrounding environment is prevented, by exhausting an used gas from the vicinity of treatment section, where plasma and the article to be treated are in contact, to protect the article to be treated and the treatment section from an oxidizing atmosphere and other contaminating atmosphere, as well as by maintaining the vicinity of treatment section under a specified gas atmosphere to prevent flow-out of the treatment gas to outside and flow-in of external atmosphere into the treatment section. The present invention will be described in detail hereinbelow.

The above-described "under a pressure near the atmospheric pressure" means under a pressure of from $1.333 \times 10^4$ to $10.664 \times 10^4$ Pa. Among others, a range from $9.331 \times 10^4$ to $10.397 \times 10^4$ Pa is preferable due to an easiness in pressure control and simplicity of the equipment.

According to the method for plasma treatment under the atmospheric pressure and the equipment therefor of the present invention, a treatment in an open system or in such a low level of airtight system as to prevent a free gas leak becomes possible.

A treatment gas used in the present invention is not specifically limited as long as it can generate plasma by applying an electric field, and various kinds of gas may be used depending on a purpose of treatment.

As a raw material gas as a raw material of a thin film, for example, a silane containing gas such as $SiH_4$, $Si_2H_6$, $SiCl_4$, $SiH_2Cl_2$ and $Si(CH_3)_4$ is used to form an amorphous silicon film and a polysilicon film, and the above silane containing gas and a nitrogen containing gas such as anhydrous ammonia and nitrogen gas are used to form a SiN film.

Further, a silane containing gas such as $SiH_4$, $Si_2H_6$ and tetraethoxysilane and an oxygen gas can be used to obtain an oxide film such as $SiO_2$.

Further, a mixed gas of $Al(CH_3)_3$, $In(C_2H_5)_3$, $MoCl_6$, $WF_6$, $Cu(HFAcAc)_2$ and $TiCl_6$ or a silane gas such as $SiH_4$ can be used to form a thin film of metal such as Al, In, Mo, W and Cu and a metal silicide thin film such as $TiSi_2$ and $WSi_2$.

Further, $In(Oi\text{-}C_3H_7)_3$, $Zn(OC_2H_5)_2$, $In(CH_3)_3$, $Zn(C_2H_5)_2$ and the like are used to form a transparent conductive film such as $In_2O_3 + Sn$, $SnO_2 + Sb$, $ZnO + Al$, and the like.

Further, $B_2H_6$ or $BCl_3$ and $NH_3$ gas and the like are used to form a BN film, a $SiF_4$ gas and an oxygen gas and the like are used to form a SiOF film, and $HSi(OR)_3$, $CH_3Si(OR)_3$, $(CH_3)_2Si(OR)_2$ and the like are used to form a polymer film and the like.

Further, $Ta(OC_2H_5)_5$, $Y(OiC_3H_7)_3$, $Y(C_2H_5)_3$, $Hf(OiC_3H_7)_4$, $Zn(C_2H_5)_2$ and the like are used to form an oxide film such as $Ta_2O_5$, $Y_2O_3$, $HfO_2$, $ZnO_2$.

In addition, a fluorine containing compound gas such as $CF_4$, $C_2F_6$, $CF_3CFCF_2$ and $C_4F_8$, an oxygen containing compound gas such as $O_2$, $O_3$, $H_2O$, $CH_3OH$ and $C_2H_5OH$; a nitrogen containing compound gas such as $N_2$ and $NH_3$; a sulfur containing compound gas such as $SO_2$ and $SO_3$; and a polymerizable hydrophilic monomer gas such as acrylic acid, methacrylamide and poly ethylene glycol dimethacrylate ester can be used depending on a purpose of each treatment.

Further, a halogen containing gas is used to perform an etching treatment or a dicing treatment, an oxygen containing gas is used to perform a resist treatment or a removal of organic contaminants, and also plasma of an inert gas such as argon and nitrogen can be used to perform a surface cleaning or a surface modification.

In the present invention, the above-described raw material gas may be used as the treatment gas as it is, but the raw material gas may also be diluted with a dilution gas to be used as the treatment gas, in view of economy and safety. The dilution gas used includes a rare gas such as neon, argon and xenon, and nitrogen.

They may be used alone or in combination of at least two kinds thereof. Conventionally, a treatment in the presence of helium had been conducted in a condition under a pressure near the atmospheric pressure. However, by using the method according to the present invention wherein a pulse-like electric field is applied between electrodes, a stable treatment becomes possible in an argon or a nitrogen atmosphere which is cheaper in comparison with helium, as described above.

The electrode described above includes those made of a simple substance of metal such as copper and aluminum, an alloy such as stainless steel and brass, an intermetallic compound and the like. The above-described opposing electrodes preferably have a structure in which a distance between the opposing electrodes is approximately constant, to avoid generation of an arc discharge due to a concentrated electric field. An electrode structure satisfying this condition includes those of a parallel flat plates type, a cylinder opposing flat plate type, a sphere opposing flat plate type, a hyperboloid opposing flat plate type and a coaxial cylinders type.

Alternatively, as a structure other than those which distance between electrodes are approximately constant, a cylinder opposing cylinder type with large cylinders having large curvatures may also be used as the opposing electrodes, because the structure has less possibility in occurrence of the electric field concentration causing the arc discharge. A curvature is preferably at least 20 mm in a radius. A curvature not larger than 20 mm in a radius tends to generate the arc discharge by the electric field concentration, although it depends on a dielectric constant of the solid dielectric. The curvatures of the opposing electrodes may be different from each other, as long as each curvature is not less than the value. Since a larger curvature makes the electrode more likely to be an approximately flat plate, providing a more stable discharge, the curvature is more preferably not less than 40 mm in a radius.

Further, with regard to the electrodes to generate plasma, a solid dielectric may be provided on at least one of a pair of electrodes, and the pair of electrodes may be arranged to be opposing each other or orthogonal with an appropriate distance between them not to make a short circuit.

The above-described distance between electrodes may suitably be determined considering a thickness of solid dielectric, a voltage to be applied, a purpose to use plasma, and the like, but it is preferably 0.1 to 50 mm. The distance less than 0.1 mm may not be sufficient for placing electrodes with an appropriate distance thereof. The distance over 50 mm makes difficult to generate an uniform discharge plasma.

The above-described solid dielectric may be provided on either one or both of the opposing faces of electrodes. In this connection, it is preferable that the solid dielectric is in close contact with the electrode on which the solid dielectric is provided and completely covers an opposing face of the electrode. This is because if there is an area remaining uncovered with the solid dielectric where electrodes themselves are opposing each other directly, the arc discharge tends to be easily generated at the area.

A shape of the above-described solid dielectric may be sheet-like or film-like, and a thickness thereof is preferably from 0.01 to 4 mm. Too thick solid dielectric may require a high voltage to generate discharge plasma, whereas too thin solid dielectric may lead to a generation of the arc discharge due to dielectric breakdown when voltage is applied. Further, as a shape of the solid dielectric, a vessel type may also be used.

A material of solid dielectric includes plastics such as poly(tetrafluoroethylene) and poly(ethylene terephthalate); glass; metal oxides such as silicon dioxide, aluminum oxide, zirconium dioxide and titan dioxide; complex oxide such as barium titanate; multilayered ones thereof; and the like.

In particular, the solid dielectric preferably has a specific dielectric constant of not less than 2 (at 25 °C atmosphere, hereinafter the same) . Specific examples of the solid dielectric with a particular specific dielectric constant of not less than 2 include poly(tetrafluoroethylene), glass, metal oxides and the like. Further, use of the solid dielectric with a specific dielectric constant of not less than 10 is more preferable to stably generate high density discharge plasma. An upper limit of specific dielectric constant is not specifically limited, but practical materials with a value of about 18, 500 are known. As the solid dielectric with the specific dielectric constant of not less than 10, a solid body made of, for example, a metal oxide film made by mixing 5 to 50 % by weight of titan oxide and 50 to 95 % by weight of aluminum oxide or a metal oxide film containing zirconium oxide, which has a thickness of 10 to 1,000 μm, is preferably used.

An electric field such as high frequency wave, pulse wave and microwave is applied between the above-described electrodes to generate plasma, and preferably a pulse electric field is applied.

It is known that under a pressure near the atmospheric pressure, a gas other than the specified gas such as helium and ketone cannot maintain a stable plasma discharge state but to instantaneously shift to the arc discharge state. However, it is understood that a cycle of stopping discharge before shifting to the arc discharge and restarting discharge can be stably realized, by applying the pulse-like electric field.

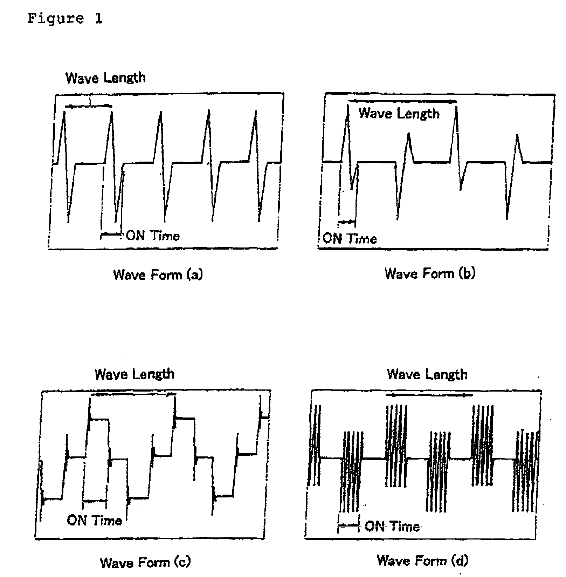

The pulse-like electric field includes an impulse type of wave forms of (a) and (b), a pulse-type of wave form of (c) and a modulated type of waveform of (d) as shown in Fig. 1. Fig. 1 shows the cases when voltages of plus and minus are applied repeatedly, but a type of pulse electric field in which voltage is applied only in either side of plus or minus pole may be used. Further, the pulse electric field in which a direct current is superposed may be applied. The wave form of pulse electric field in the present invention is not limited to those described above, but may be further modulated with a pulse with a different wave form, rise time or frequency.

The above-described rise time and/or decay time are preferably not longer than 10 μs. The times over 10 μs tend to cause the discharge state to shift to the arc discharge and become unstable, making it difficult to maintain a high densityplasma state by the pulse electric field. In addition, a shorter rise time or decay time provides more efficient gas ionization in plasma generation, but the pulse electric field with the rise time less than 40 ns is difficult to be practically realized. The times are, therefore, more preferably from 50 ns to 5 μs. In this connection, the rise time here means a period during which a voltage (absolute value) increases continuously, and the decay time means a period during which the voltage (absolute value) decreases continuously.

Further, the decay of pulse electric field should also be preferably steep, and the decay time is preferably of not longer than 10 μs in a time scale similar to the rise time. It is preferable that the rise time and the decay time can be set to the same time, although it depends on a technology to generate the pulse electric field.

Field strength of the above-described pulse electric field is preferably set to be 10 to 1000 kV/cm. The field strength lower than 10 kV/cm requires too long treatment time, whereas the strength over 1000 kV/cm tends to generate the arc discharge.

Frequency of the above-described pulse electric field is preferably not less than 0.5 kHz. The frequency legs than 0.5 kHz requires too long treatment time due to a low plasma density. An upper limit in the frequency is not specifically limited, but such high frequency bands as 13.56 MHz commonly used and 500 MHz in test use may be used. The frequency not higher than 500 kHz is preferable in consideration of easiness in adjusting with load and handling. A treatment speed is greatly improved by applying the pulse electric field as described above.

Further, duration time for one pulse in the above-described pulse electric field is preferably not longer than 200 μs. The duration time over 200 μs tends to cause a shift to the arc discharge. The more preferable duration time is 3 to 200 μs. In this connection, the duration time for one pulse here means a continuous "ON time" of one pulse in the electric field consisting of repeating "ON" and "OFF", as shown in Fig.1.

The article to be treated in the present invention includes semiconductor element; metal; plastics such as polyethylene, polypropylene, polystyrene, polycarbonate, poly(ethylene terephthalate), poly(tetrafluoroethylene), polyimide, liquid crystal polymer, epoxy resin and acrylate resin; glass; ceramics; and the like. A shape of the article to be treated includes plate-like and film-like, but not specifically limited to them. According to the present invention, the treatment method in accordance with. the present invention can easily respond to the article to be treated with various shapes.

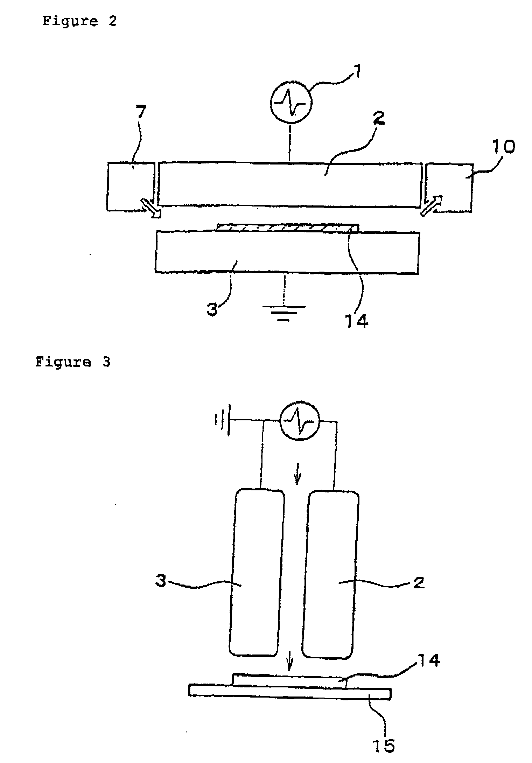

With regard to a means to make plasma in contact with the article to be treated includes: for example, (1) making plasma in contact with the article to be treated 14 by placing the article to be treated 14 in the discharge space of plasma generated between opposing electrodes 2 and 3, as shown in Fig. 2; and (2) making plasma in contact with the article to be treated 14 by introducing the plasma generated between opposing electrodes 2 and 3 toward the article to be treated 14 placed outside of the discharge space, as shown in Fig. 3 (hereinafter, the latter may be referred to a remote method).

A practical method for the above-described (1) includes: a method for contacting plasma with the article to be treated placed between the parallel flat plate type electrodes coated with the solid dielectric, wherein a treatment is performed by shower-like plasma using an upper electrode having many holes; a method wherein a film-like substrate travels through the discharge space; and a method wherein a vessel-like solid dielectric having a blow nozzle is placed on one electrode and plasma is blown from the nozzle onto the article to be treated placed on another electrode.

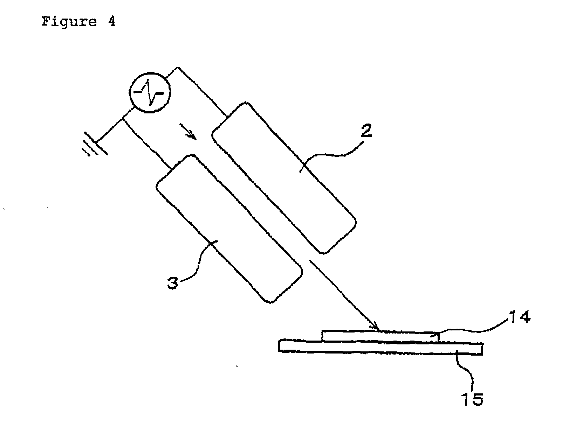

In addition, a practical method for the above-described (2) includes a method wherein the solid dielectric is extended to form a plasma introducing nozzle which blows out plasma toward the article to be treated placed outside of the discharge space, and the like. In this method, a combination of the parallel flat plate type electrodes and the long nozzle or coaxial cylinder type electrodes and a cylinder type nozzle can be used. In this connection, a material of nozzle tip is not necessarily the above-described solid dielectric, and a metal may be used as long as insulation from the above-described electrodes is secured. Further, a direction of plasma to be blown may be any direction other than the direction rectangular to the article to be treated 14, as shown in Fig. 4 (hereinafter, an equipment using the method of (2) may be referred to a remote source).

The remote method, among others, in which plasma, generated between opposing electrodes, is blown to the article to be treated through the solid dielectric having the gas blow nozzle, is a method with reduced electric and thermal loads to a substrate, because the material being the article to be treated is less directly exposed to high density plasma space and the gas in plasma state can be delivered only to an intended position on the surface of substrate to perform treatment.

In the treatment method in accordance with the present invention, in order to prevent an exhaust gas from flowing out to the exterior atmosphere after treating the article to be treated by the above-described method, and also preferably a treated organic substance and the like from re-adhering to the article to be treated, it is required to exhaust the used gas from the vicinity of treatment section where plasma and the article to be treated are in contact. Further, in order to positively heat up the article to be treated, prevent the surface of the article to be treated before treatment from oxidation, prevent the article to be treated from temperature rise during treatment, protect the surface of the article to be treated after treatment, prevent the exhaust gas from flowing out to the exterior atmosphere, recover the gas and the like when plasma generated between electrodes is contacted with the article to be treated, it is necessary to maintain the vicinity of treatment section for the article to be treated under the specified gas atmosphere and use a recovery mechanism for the gas.

Therefore, the equipment in accordance with the present invention needs to have an exhaustion equipment for the used gas and an atmosphere control mechanism to maintain the vicinity of treatment section, where plasma and the article to be treated are in contact, under the specified gas atmosphere using the specified gas and the like, and control flowing out of the used gas as well as flowing in of a gas from the external atmosphere.

In this connection, the specified gas here includes nitrogen, argon, helium, neon, xenon, and the like. In addition, dry air may be used in such a case as a treatment in which an oxide film is formed where an influence of oxygen is less.

Hereinbelow, practical examples will be described using drawings on the exhaustion mechanism for the used gas after treatment, the gas curtain mechanism by the specified gas and the mechanism to prevent flowing in and flowing out of gas through the whole equipment.

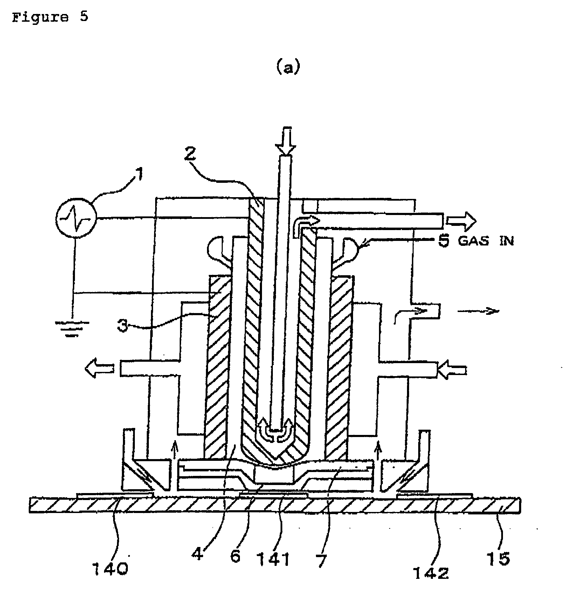

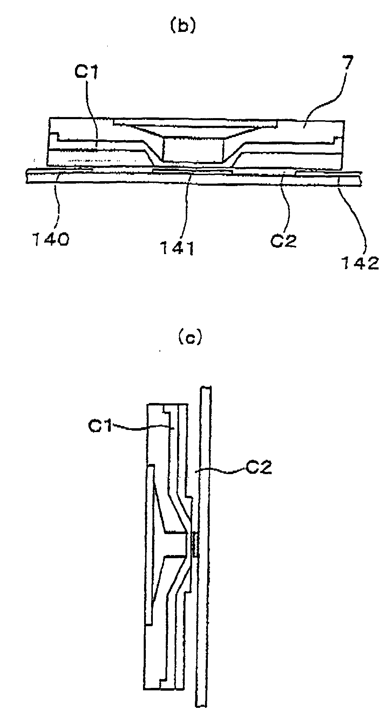

Fig. 5 explains an example of the equipment for controlling gas passages composed of a passage for plasma gas blow using the remote source, a passage to the exhaust gas exit and a space for sealing a gas flow to the vicinity of treatment section. Fig. 5(a) is a schematic cross-sectional view of an example of a coaxial quasi-cylindrical type equipment for plasma discharge treatment as a whole, Figs. 5(b) and 5(c) are magnified drawings of a front and a side cross-sectional views, respectively, for the peripheral section of plasma blow opening, and Fig. 5(d) is a bottom view drawing viewed from the lower side of the plasma blow opening. In Fig. 5(a), discharge space 4 is formed between a quasi-cylindrical inner electrode 2 and a quasi-cylindrical outer electrode 3. Plasma blow opening 6 is baffled so as to have a smaller diameter than that of discharge space 4 by a nozzle member 7 made of the solid dielectric and is designed so that plasma blows out to outside of the discharge space. The cylindrical inner electrode 2 and the cylindrical outer electrode 3 have a cooling function and cool the electrodes themselves by introducing and recovering a coolant along a direction shown by the white arrows. The treatment gas is introduced from introduction inlet 5 to discharge space 4, flows through the discharge space 4, plasmatized by the electric field applied between electrodes by a power source 1, then blown from gas blow opening 6 onto a micro-article to be treated 141 placed on the support for the article to be treated 15 traveling.

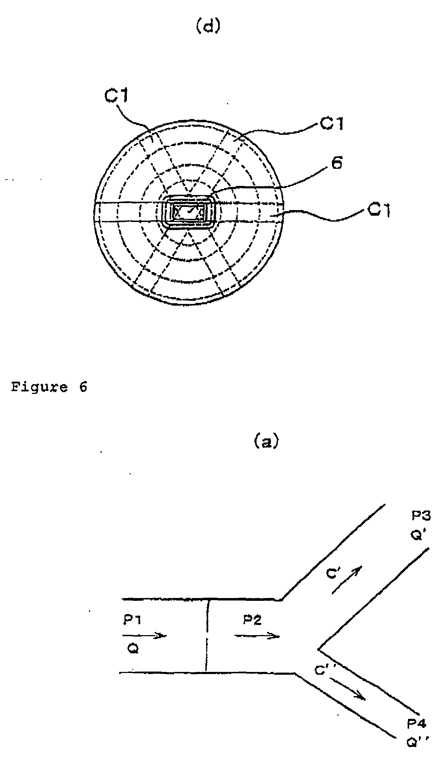

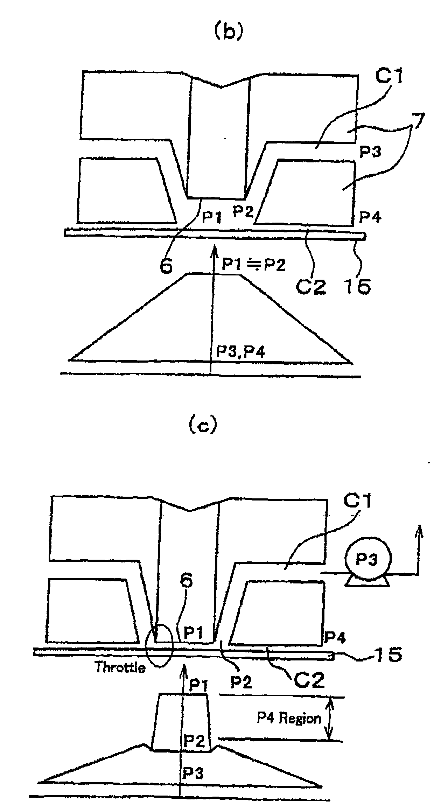

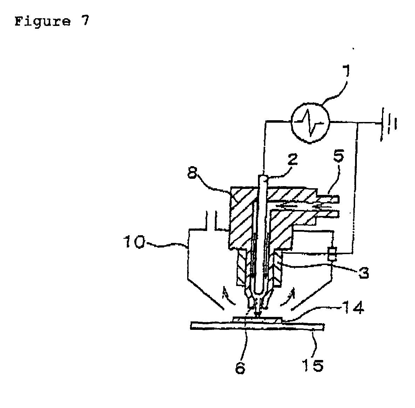

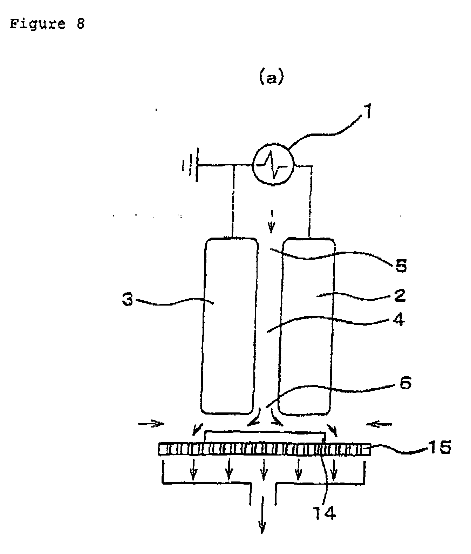

By using the equipment having a structure shown in Fig. 5, the plasma gas is blown out from the blow opening 6 to treat the micro-article to be treated 141, and the used gas flows along a direction of a passage C1 instead of a direction of a passage C2 contacting with adjacent articles to be treated 140 and 142 placed on a support. Thus an exhaustion is performed efficiently without affecting adjacent bodies to be treated 140 and 142. Fundamental principle of the flow is explained in Fig. 6. Fig. 6 (a) is a drawing to explain a relation between flow volume and pressure when the passage has a baffle, then the passage is divided into two passages. Provided that total flow volume is Q (introduced gas volume), flow volumes in branched passages are Q' (flow volume of exhaust gas) and Q" (leak volume), respectively, pressure in front of the baffle is P1, pressure in the rear side of the baffle is P2, pressure at an exit of each passage is P3 and P4, respectively, then the following relationships hold:

$$Q = Q' + Q''$$

$$Q' = C'(P2 - P3)$$

$$Q'' = C''(P2 - P4)$$

wherein, P1 > P2, and C' and C" are conductance.

In this connection, to reduce leak volume Q", it is effective to reduce (P2 - P4) and further increase (P2 - P3).

Therefore, in Fig, 6 (b), showing schematically a passage in the periphery of gas blow opening 6 in Fig. 5, if a cross-sectional area of leak gas passage C2 is sufficiently reduced by sufficiently increasing an area of exhaust gas passage C1 and further by sufficiently decreasing a clearance from the article to be treated 141, then a relation of C' > C" can be attained and thus most of the introduced gas volume can be exhausted and an effect of leakage can be reduced. Further, when a clearance from the article to be treated cannot be reduced or a conductance of exhaust gas passage cannot be increased, a relation of (P2 - P4) ≦ 0 can be attained to make leak flow volume Q" zero, by providing the baffle at an entrance of exhaust gas passage to reduce P2 and further by compulsively exhausting from the exhaust gas exit as shown in Fig. 6 (c). In addition, a compulsive exhaustion by a vacuum pump and the like enables to realize a relation of (P2 - P3) > 0 and also an exhaustion under a relation of Q' > Q + a. Here, a corresponds to a back-flow volume of the external air from a clearance between the nozzle and the article to be treated, and thus a complete sealing can be attained.

As described above, when a small area is selectively treated, an efficient treatment and exhaustion can be performed by providing the exhaust gas passage as described above in the periphery of the plasma blow nozzle.

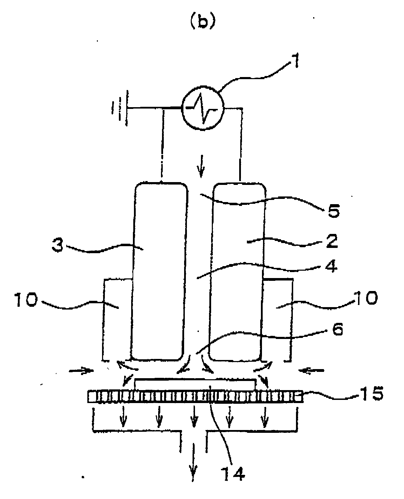

Fig. 7 is a schematic drawing of an example of unit whereby plasma gas is blown to the article to be treated using a solid dielectric nozzle of the coaxial cylinder type electrode and the used gas is exhausted through a doughnut-like gas exhaustion exit provided in the periphery of the gas blow nozzle. The treatment gas is introduced from treatment gas inlet 5 to the cylindrical solid dielectric vessel along a direction shown by the arrows, plasmatized by applying the electric field between electrode 3 provided outside of the cylindrical solid dielectric vessel and an inner electrode 2 provided inside of the cylindrical solid dielectric vessel from power source 1, and blown out from gas blow opening 6 to treat the article to be treated 14 placed on support 15 which also acts as a conveyer belt and the like. By using such a structure in an etching treatment and the like, an organic substance after etching is removed from exhaust gas cylinder 10 together with the used gas after etching treatment without any contamination by re-adhesion thereof onto the article to be treated 14. Further, leak of the treatment gas to outside can be prevented by enclosing the whole remote source having gas blow opening 6 in a simple vessel, which is filled with the specified gas such as an inert gas. An extent of treatment can be varied by using the conveyor belt which can be freely adjusted in a traveling speed thereof, and further a cooling or a heating mechanism may also be added thereto. A nozzle body made of the cylindrical solid dielectric may also be equipped with a nozzle waiting mechanism, if necessary, which allows the nozzle to wait outside of the article to be treated until plasma is stabilized while a preliminary discharge is conducted after a voltage is applied between electrodes, or equipped with a X-Y-Z shifting mechanism to sweep on the article to be treated.

Fig. 8 is a schematic drawing of a suction unit to suck the exhaust gas after blown onto the article to be treated 'from the remote source, from the backside of the support having a number of holes, downward in an alignment of Fig. 8. The treatment gas is introduced from treatment gas inlet 5 to a discharge space 4 formed by electrodes 2 and 3 along a direction shown by the arrows, and plasmatized by applying the electric field from the power source 1, and blown out from the gas blow opening 6 to treat the article to be treated 14 placed on the support 15. Since the support 15 has a number of open holes, the article to be treated can be fixed onto the support by being sucked from the backside thereof as well as the used gas and an excess treatment gas can be removed downward. Therefore, a stationary downward gas flow can be made compulsively to improve treatment accuracy. Further, since a flow of gas flowing in from the periphery of the remote source is formed and the used gas is confined therein, there is an advantage that the gas from the remote source does not leak to outside. Fig. 8 (b) is an equipment of a combined type of the used gas suction unit (exhaustion member 10) provided in the periphery of gas blow opening 6 shown in Fig. 7 and a downward suction unit provided on the support 15 to perform treatment and recovery efficiently.

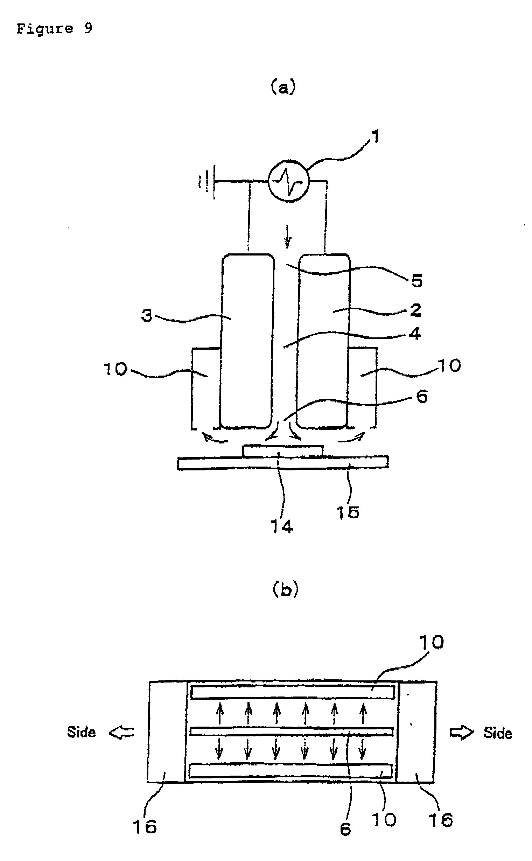

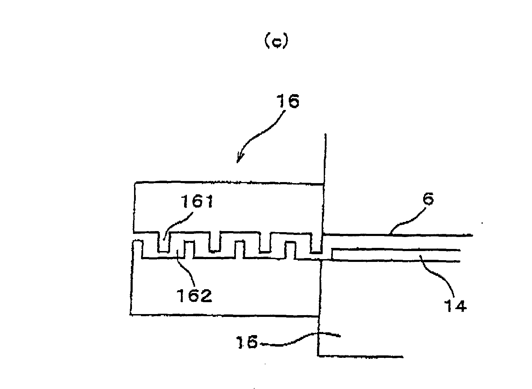

Fig. 9 is a drawing to explain a side seal to prevent a gas flowing out to outside and a gas flowing in from outside through both sides of the plasma treatment section orthogonally to a traveling direction of said article to be treated, in the exhaustion unit for the used gas after blown onto the article to be treated from the remote source having an extended length of nozzle equipped orthogonally to the traveling direction (the vertical direction against this paper plane). Fig. 9 (a) is an example of equipment whereby the plasma obtained by introducing the treatment gas into the discharge space 4 between the parallel flat plate type electrodes 2 and 3 is blown from the long nozzle type of gas blow opening 6 onto the article to be treated 14 on the conveyor support 15 to perform the treatment, and the used gas is exhausted from the exhaustgas exit 10. This equipment corresponds to the coaxial cylinder type electrodes shown in Fig. 7, and in the equipment having the long nozzle, a turbulent gas flow in a flowing direction often causes an uneven thickness of a thin film formed on the surface of the article to be treated. In particular, the unevenness tends to appear remarkably, if the gas blown out from gas blow opening 6 does not flow evenly toward exhaust gas exit 10 but there is a gas flow toward side clearances (both sides of the plasma treatment section orthogonally to a traveling direction of said article to be treated), therefore it is preferable to provide a side seal mechanism. Fig. 9 (b) is a bottom view of Fig. 9 (a) viewed from a side of plasma flowing out opening. A gas blown out from gas blow opening 6, after treating the article to be treated, forms an uniform flow toward exhaust gas exit 10, without generating a gas flow leaking toward sides due to presence of the side seal mechanism 16, and thus forms an uniform thin film and the like on the surface of the article to be treated. Fig. 9 (c) is an example of labyrinth seal, a type of the side seal mechanism. The labyrinth seal is a seal mechanism to prevent a leak of fluid by providing a means such as fitting a baffle in a clearance passage between a movable part and a fixed part. That is, in this equipment, the seal mechanism is used to prevent a leak of plasma gas in a clearance between the movable support to convey the article to be treated and the fixed remote source, and can suppress flowing out of plasma gas to outside while conveying the support without friction, by providing baffles 161 and expansion rooms 162 along the traveling direction of the conveyor at the fixed remote source side and the movable support side alternatively so as to be engaged each other. In this connection, a shape of this labyrinth may be determined depending on plasma gas flow volume as well as size and shape of the remote source.

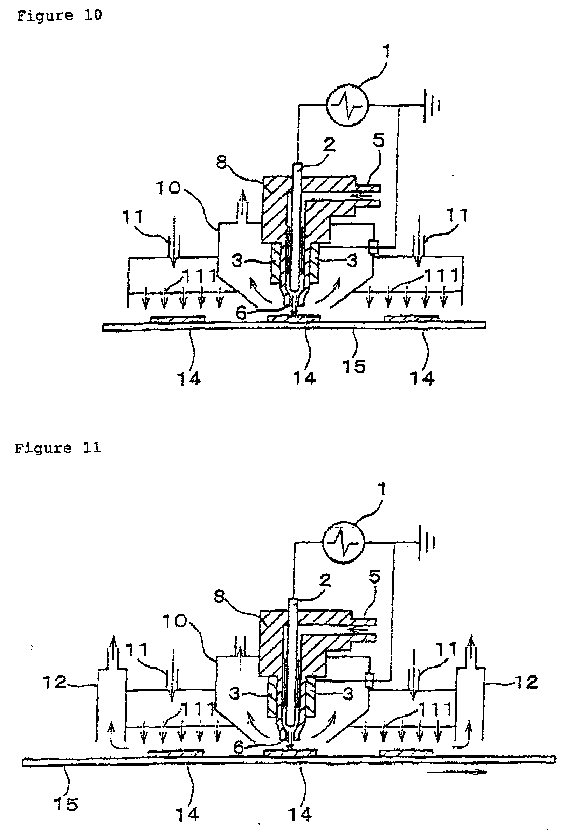

Fig. 10 is a schematic drawing of an example of equipment to maintain the vicinity of treatment section, where plasma and the article to be treated are in contact, under the specified gas atmosphere by possessing the gas exhaustion mechanism in the periphery of the vicinity of treatment section, where plasma and the article to be treated are in contact, and the gas curtain mechanism added with the gas shower function by the specified gas such as an inert gas in the periphery of the gas exhaustion mechanism. The treatment gas is introduced from treatment gas inlet 5 into the cylindrical solid dielectric vessel of the coaxial cylinder type electrodes along a direction shown by the arrows, plasmatized by applying the electric field between the outer electrode 3 and the inner electrode 2, and blown out toward the article to be treated 14 from blow opening 6, then exhausted and recovered from the inner circumferential exhaust gas cylinder 10. On the other hand, the specified gas is introduced from specified gas inlet 11, and blown out from specified gas blow pores 111 located underneath toward the article to be treated 14 conveyed to maintain an atmosphere surrounding the article to be treated under the specified gas atmosphere by acting as a gas curtain. The specified gas is sucked and recovered from the inner circumferential exhaust gas cylinder 10 together with the used gas. This method has an advantage to be able to prevent a gas leak to sides and an external contamination such as water intrusion into the treatment section by selecting a gas such as an inert gas.

Fig. 11 is a schematic drawing of another example of equipment to maintain the vicinity of treatment section, where plasma and the article to be treated are in contact, under the specified gas atmosphere, by possessing the gas exhaustion mechanism in the periphery of the vicinity of treatment section, where plasma and the article to be treated are in contact, and the gas curtain mechanism added with the gas shower function by the specified gas in the periphery of the gas exhaustion mechanism. The treatment gas is introduced from treatment gas inlet 5 into the cylindrical solid dielectric vessel of the coaxial cylinder type electrodes along a direction shown by the arrows, plasmatized by applying the electric field between the outer electrode 3 and the inner electrode 2, blown out from blow opening 6 onto the article to be treated 14, and then sucked and recovered from the inner circumferential exhaust gas cylinder 10. On the other hand, the specified gas is introduced from specified gas inlet 11, and blown out from specified gas blow pores 111 located underneath toward the article to be treated 14 conveyed to maintain an atmosphere surrounding the article to be treated under the specified gas atmosphere by acting as the gas curtain. The specified gas is recovered from exhaust gas exit 12. This method has an advantage to be able to prevent a gas leak to sides and a contamination of an external gas such as water intrusion into the treatment section by selecting a gas such as an inert gas. In this connection, the above gas exhaustion mechanism may be used not only in the periphery of nozzle but also in other places for local exhaustion.

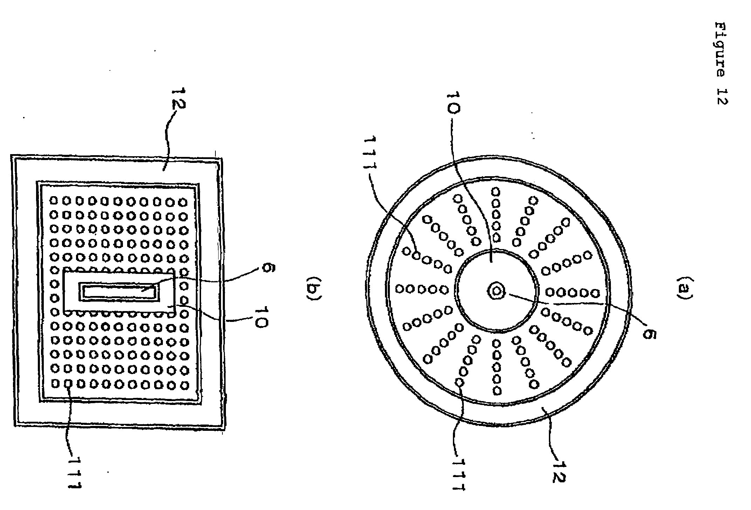

In this connection, the equipment to provide the specified gas shower function in Fig. 11 preferably has a bottom face like those shown in Fig. 12 (a) and Fig. 12(b). Fig. 12 (a) is the specified gas shower equipment for the case using a coaxial cylinder type nozzle and corresponds to a bottom face of the nozzle part in Fig. 10 or 11. The plasma gas is blown out from gas blow opening 6 to treat the article to be treated, then exhausted from the inner circumferential exhaust gas cylinder 10. In addition, the specified gas is blown out from specified gas blow pores 111 locating in the specified gas shower region, and exhausted from exhaust gas exit 12 provided in the whole outer circumference. Fig. 12 (b) is the specified gas shower equipment for the case using a vertical flat plane type long nozzle. Plasma gas is blown out from gas blow opening 6 to treat the article to be treated, then exhausted from the inner circumferential exhaust gas cylinder 10. In addition, the specified gas is blown out from specified gas blow pores 111 locating in the specified gas shower region, and exhausted from exhaust gas exit 12 provided in the whole outer circumference.

In Figs.10 and 11, the article to be treated 14 is conveyed on the support which also acts as a conveyor belt, and an extent of treatment on the article to be treated can be controlled by using the conveyor belt having freely adjustable feeding speed. Further, the conveyor belt with a heating function may also be used, if necessary. In addition, the conveyor belt may have a mechanism to shift the nozzle, which is integrated with the exhaustion mechanism and the specified gas shower mechanism, in a traveling direction of the support, a horizontally orthogonal direction thereto and a vertically orthogonal direction thereto, and the integrated nozzle structure may also be scanned.

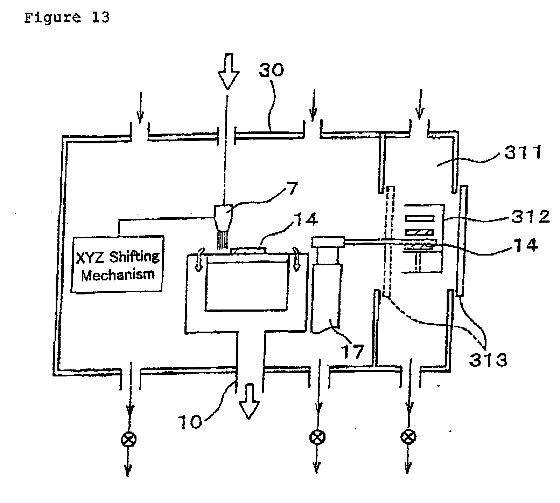

Fig. 13 is a schematic drawing of an example of equipment to explain a method for conducting the treatment using the remote source in a vessel filled with the specified gas. In the equipment of Fig. 13, the vessel 30 for the specified gas has a carrying in/out room 311 to use a carrier robot 17 for the article to be treated 14 and a shutter 312 therefor, and is required only to always feed and exhaust the specified gas and air tightness is not necessary. In addition, a vacuum pump is not required but a simple blower type exhauster is enough. Further, the vessel 30 for the specified gas is not required to be pressure proof but a simple chamber is enough. In the treatment equipment enclosed in the vessel 30 for the specified gas, the treatment gas is introduced to the remote source 7 equipped with a X-Y-Z shifting mechanism, and blown onto the article to be treated 14 to perform treatment. The used gas is exhausted from the exhaust gas cylinder 10. Further, the article to be treated 14 is carried in/out from a cassette 312 in the carry in/out room 311 by the carrier robot 17. In addition, a treated product is carried in/out through the shutter 313.

The method for treatment in the vessel filled with the specified gas has, in particular, such advantages as: the article to be treated can be conveyed without using a preparatory room and the like; treatments such as a continuous treatment and a treatment for a sheet-like product can be easily responded; and the treatment gas can be stably introduced separately.

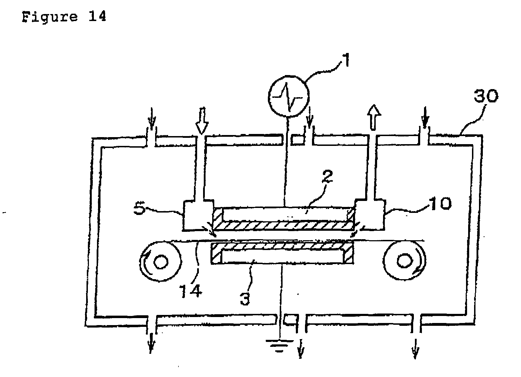

Fig. 14 is a schematic drawing of an example of equipment to explain the method for treatment by placing articles to be treated as one unit between electrodes in the vessel filled with the specified gas. Since the vessel 30 has the same function as in Fig. 13 and is for an equipment for treating a continuous body such as film and sheet, the whole conveying system composed of a delivery roll and a take-up roll is enclosed in the vessel 30, and the treatment gas is introduced from treatment gas inlet 5 into the discharge space between electrodes 2 and 3 to perform a treatment of the article to be treated 14 simultaneously. This equipment can perform a superior quality of treatment under the specified gas atmosphere, however, the equipment itself may sometimes become too big.

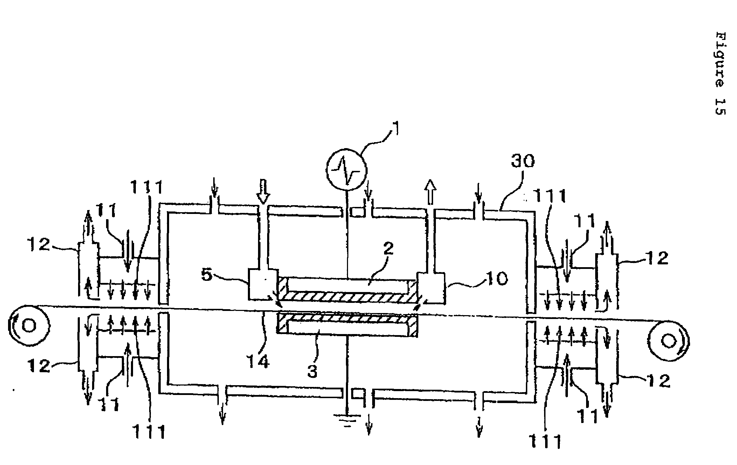

Fig. 15 is a schematic drawing to explain the equipment for plasma treatment by placing the article to be treated between opposing electrodes in the vessel filled with the specified gas. The treatment gas is introduced from treatment gas inlet 5 into the discharge space between electrodes 2 and 3, plasmatized to treat the article to be treated 14 conveyed in continuously, and then recovered from exhaust gas exit 10. The vessel 30 enclosing the whole plasma treatment section is filled with the specified gas, and designed so that a part of the gas can flow through. Although the vessel is always sealed from the exterior atmosphere, in order to completely seal the exterior atmosphere accompanied to the article to be treated 14 conveyed in, it is equipped with the gas curtain mechanism shown in Fig. 11 against both sides of top and bottom of the article to be treated 14 at the carrying in/out opening for the article to be treated 14.

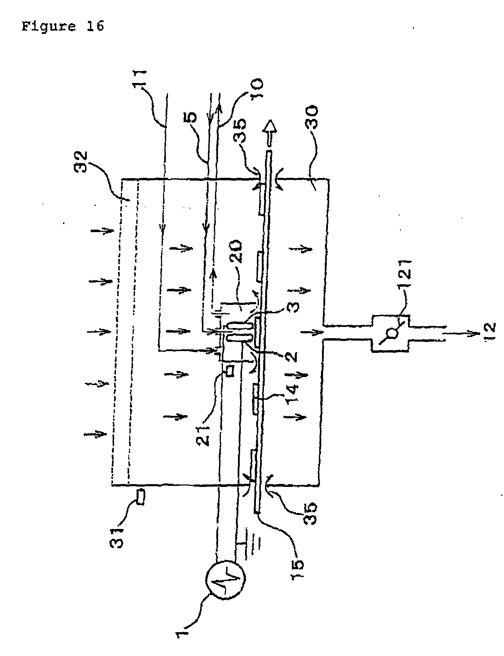

Fig. 16 is a schematic drawing to explain an example of equipment for treating the article to be treated conveyed continuously using the remote source. In Fig. 16, chamber 20 is the plasma treatment section for treating the article to be treated 14 with plasma, and chamber 30 is the vessel to enclose the chamber 20, and each of chambers 20 and 30 is equipped with pressure gauges 21 and 31, respectively, to control pressures thereof. This equipment can prevent a diffusion of treatment gas to the periphery as well as contamination of the exterior air by controlling the pressure of each chamber. Therefore, each room of chambers 20 and 30 is not required to be a strictly airtight vessel such as, in particular, a vacuum container. Further, since the vessel has an opening to carry in the article to be treated and carry out the treated article, the vessel simply manufactured using a material such as synthetic resins may be used.

In addition, chamber 20 may optionally have a structure integrated with electrodes and the like.

Practically, in chamber 20, the treatment gas is introduced via the treatment gas introduction line 5 into the discharge space between electrodes 2 and 3 in the chamber 20, plasmatized by applying the electric field between electrodes from power source 1, and treats the article to be treated 14 placed on the support 15 which acts as the conveyor belt and carried in. Most of the used gas after plasma treatment is recovered by exhaust gas recovery line 10. Chamber 20 is maintained under an atmosphere of a gas which does not affect the treatment gas such as clean dry air and specified gas, and kept at a higher pressure than a pressure in chamber 30. The environmental gas (specified gas and the like) is introduced via the environmental gas introduction line 11 to the upper part of chamber 20, flows through inside of chamber 20, then flows out into chamber 30 together with a part of the exhaust gas after treatment. Since the pressure in chamber 30 is lower than the exterior atmospheric pressure by a predetermined pressure value in order to prevent leak of the gas from chamber 20 to outside, a fixed volume of the exterior air flows in to chamber 30 from openings 35 at both sides and via a rectifier plate 32 provided in an upper part. The exterior air flowed in is recovered via whole exhaust gas line 12 together with flowed-out gas from chamber 20 and the like. The pressure in chamber 30 is controlled by a pressure control valve 121. In this connection, it is required to hold the following relationship among pressures in chambers 20 and 30 and the external air pressure: pressure in chamber 20 > pressure in chamber 30; and pressure in chamber 30 < external air pressure. Values of pressure differences among those of chambers 20, 30 and the external air are not specifically limited, however, a small pressure difference of the level Of around several mm $H_2O$ is sufficient, which is not difficult to be adjusted. As the external air, clean air is preferable in the view point of treatment accuracy. In addition, in a treatment which requires strict avoidance of an effect of the external air, such as plasma CVD treatment, an unit composed of not only chambers 20 and 30 but also an intermediate chamber further added may be employed.

The pressure in each chamber and pressure differences among those chambers and the external air can be adjusted not only by feeding an environmental gas but also by controlling a feed rate of the treatment gas and an exhaustion rate of the used gas. Thus, by controlling pressures in chambers, diffusion of the treatment gas to outside of the equipment can completely be prevented as well as a contamination of the exterior air into the treatment section can be prevented.

In this connection, for example, if a pressure in the production room as a whole, where the treatment equipment is installed, is designed to be higher than the atmospheric pressure and the pressure in chamber 30 is designed to be the same to the atmospheric pressure, the exhaust pump from chamber 30 can be omitted by providing a direct exhaustion route from the treatment equipment to outside of the production room.

The discharge under the at mospheric pressure using the electric field, in particular, the pulse electric field of the present invention, can generate the discharge directly between electrodes under the atmospheric pressure, completely independently from a type of gas, and thus enables to realize the equipment and the treatment procedure for plasma treatment under the atmospheric pressure using more simplified electrode structure and discharge procedure, as well as a high speed treatment. Further, parameters relating to a treatment for the article to be treated can also be adjusted by parameters such as pulse frequency, voltage and the distance between electrodes.

EXAMPLES

The present invention will be explained in detail hereinbelow using Examples, but the present invention should not be limited to these Examples only.

Example 1

Using the equipment shown in Fig. 11 and a nitrogen gas as the specified gas, plasma was generated under the following conditions while the exhaust gas was exhausted, to carry out a dry etching of 2 inch (100) of silicon wafer. The solid dielectric used was $Al_2O_3$, diameter of plasma blow pore was 1 mm and distance from plasma blow opening to substrate was 2 mm.

Plasma treatment conditions:

Treatment gas: Mixed gas of oxygen 0.1 SLM + $CF_4$ 0.4 SLM + argon 9.5 SLM.

Discharge conditions: Wave form (a), rise time / decay time 5 μs; power output 200 W, frequency 10KHz, treatment time 20 sec, and the plasma generated was an uniform discharge without an arc pillar,

Etched depth was found to be 0.2 μm from cross-sectional observation of the surface of thus obtained silicon wafer using a scanning electron microscope.

Comparative Example 1

After evacuation of a vacuum chamber, 100 sccm of a mixed gas composed of 5 % of oxygen and 95 % of $CF_4$ as a treatment gas was introduced to adjust the pressure therein to be 27 Pa, then a voltage having a sin wave form and frequency of 12.2 KHz instead of a pulse electric field was applied to carry out a surface treatment of silicon wafer for 5 min. Etched depth was found to be 0.1 μm from cross-sectional observation of the surface of thus obtained silicon wafer using a scanning electron microscope.

Comparative Example 2

Surface treatment of a silicon wafer was carried out in the same manner as in Comparative Example 1 except for setting the treatment time at 20 sec. Etched depth could not be measured by cross-sectional observation of the surface of thus obtained silicon wafer using the scanning electron microscope.

Example 2

A formation of silicon nitride film was carried out on a substrate using the equipment shown in Fig. 14, which employed a method for contacting plasma with the article to be treated in the vessel filled with the specified gas. In the equipment shown in Fig. 14, parallel flat plate type electrodes made of SUS304 stainless steel with a size of 300 mm width x 100 mm length x 20 mm thickness as an upper electrode 2 and a lower electrode 3, and a thermal-sprayed alumina with a thickness of 1 mm as the solid dielectric 4 were used. Polyimide film 14 (size of 100 x 100 mm, thickness of 50 μm) as a substrate, on which the film was formed, was arranged to travel through a space between the electrodes with a distance of 2 mm, using a delivery roll and a take-up roll.

As the treatment gas, a mixed gas composed of 0.16 % of tetramethyl silane and 16 % of ammonia was used after diluted with an argon gas. Formation of the silicon nitride film on the polyimide film was carried out by feeding the treatment gas along the direction shown by the white arrows, and applying a pulse electric field having the wave form shown in Fig. 1 (a), a rise time of 5μs, a voltage of 10 kV between the upper electrode 2 and the lower electrode 3 under a pressure of 95 kPa (under the atmospheric pressure) . Further, nitrogen gas, as the specified gas, was fed along the direction shown by the arrows into the vessel 30 to maintain the inside thereof under an inert gas atmosphere. Formation of the silicon nitride film on the treated film was confirmed. Film formation speed in this experiment was 0.42 μm/sec.

Comparative Example 3

Formation of silicon nitride film was carried out on a substrate in the same manner as in Example 2 except for not adopting the gas atmosphere control mechanism by using the vessel 30. Formation of the silicon nitride film on the film was confirmed, but oxidation of the film surface was observed by the XPS evaluation.

A method for plasma treatment under the atmospheric pressure near the atmospheric pressure in accordance with the present invention can make a treatment process a more highly accurate system, and contribute to an improvement of treatment yield, because an used gas can be exhausted from the vicinity of treatment section where plasma of treatment gas and the article to be treated are in contact, and maintain the vicinity of contact treatment section under a specified gas atmosphere. Further, by using the method in accordance with the present invention, speeding up of the whole treatment process can be realized, because the method in accordance with the present invention can be performed under the atmospheric pressure and hence easily accept an in-line operation thereof.

**Claims**

1. A method for plasma treatment under the atmospheric pressure for treating an article to be treated comprising: providing a solid dielectric on at least one opposing face of a pair of opposing electrodes under a pressure near the atmospheric pressure; introducing a treatment gas between said a pair of opposing electrodes; generating plasma by applying an electric field between said electrodes; and contacting the plasma with the article to be treated, wherein an used gas is exhausted from the vicinity of treatment section where said plasma and said body to be treated are in contact, and said vicinity of treatment section is maintained under a specified gas atmosphere by a gas atmosphere control mechanism.

2. The method for plasma treatment under the atmospheric pressure according to claim 1, wherein said exhaustion of the used gas from the vicinity of treatment section is performed by a gas passage control mechanism composed of a passage for the plasma gas blown out, a passage to an exhaust gas exit and a sealed space substantially preventing a gas flow to said vicinity of treatment section.

3. The method for plasma treatment under the atmospheric pressure according to claim 1, wherein said exhaustion of the used gas from said vicinity of treatment section is performed by an exhaustion mechanism which exhausts the used gas from the back side of a support for said article to be treated.

4. The method for plasma treatment under the atmospheric pressure according to one of claims 1 to 3, wherein said gas atmosphere controlmechanism is a mechanism whereby said vicinity of treatment section, where said plasma and said article to be treated are in contact, is maintained under the specified gas atmosphere by a gas curtain mechanism.

5. The method for plasma treatment under the atmospheric pressure according to one of claims 1 to 4, wherein said vicinity of treatment section, where said plasma and said article to be treated are in contact, is maintained under the specified gas atmosphere by providing an exhaust gas exit in the periphery of said vicinity of treatment section where said plasma and said article to be treated are in contact, and also said gas curtain mechanism in the periphery of said vicinity of an exhaust gas exit.

6. The method for plasma treatment under the atmospheric pressure according to claim 1, wherein, in the plasma treatment using a remote source having an extended length of nozzle equipped in crosswise direction of said article to be treated, an exhaust gas exit is provided in crosswise direction of the treatment section where said plasma and said article to be treated are in contact, and a side seal mechanism is provided in the lengthwise direction of said treatment section.

7. The method for plasma treatment under the atmospheric pressure according to claim 1, wherein said vicinity of treatment section, where said plasma and said article to be treated are in contact, is maintained under the specified gas atmosphere by conducting the treatment in a vessel through which the specified gas flows.

8. The method for plasma treatment under the atmospheric pressure according to claim 1, wherein at least two chambers composed of chamber 1 enclosing a discharge plasmageneration section and said article to be treated and chamber 2 enclosing said chamber 1 are provided, and those chambers are designed so that a gas flows out from said chamber 1 and the external air flows into said chamber 2 by making the pressure in said chamber 2 lower than the pressure in said chamber 1, and also lower than the external atmospheric pressure.

9. The method for plasma treatment under the atmospheric pressure according to one of claims 1 to 8, wherein said specified gas atmosphere comprises at least one kind of gas selected from the group consisting of nitrogen, argon, helium, neon, xenon and dry air.

10. The method for plasma treatment under the atmospheric pressure according to one of claims 1 to 8, wherein said electric field applied between the electrodes is a pulse-like electric field having a pulse rise time and/or a pulse decay time of not longer than 10 μs and a field strength of 10 to 1,000 kV/cm.

11. An equipment for plasma treatment under the atmospheric pressure comprising: a pair of opposing electrodes with a solid dielectric being provided on at least one opposing face thereof; a mechanism for introducing a treatment gas between said a pair of opposing electrodes; a mechanism for applying an electric field between said electrodes; a mechanism for contacting the plasma obtained by said electric field with said article to be treated; a mechanism for exhausting an used gas; and a mechanism for maintaining the vicinity of treatment section, where said plasma and said article to be treated are in contact, under the specified gas atmosphere.

12. The equipment for plasma treatment under the atmospheric pressure according to claim 11, wherein said mechanism for exhausting the used gas from said vicinity of treatment section is a gas passage control mechanism composed of a passage for said plasma gas blown out, a passage to an exhaust gas exit and a sealed space substantially preventing a gas flow to said vicinity of treatment section.

13. The equipment for plasma treatment under the atmospheric pressure according to claim 11, wherein said mechanism for maintaining said vicinity of treatment section, where saidplasma and said article to be treated are in contact, under the specified gas atmosphere is a gas curtain mechanism.

14. The equipment for plasma treatment under the atmospheric pressure according to one of claims 11 to 13, wherein said vicinity of treatment section, where said plasma and said article to be treated are in contact, is maintained under the specified gas atmosphere, by providing a gas exhausting mechanism in the periphery of said vicinity of treatment section, where said plasma and said article to be treated are in contact, and said gas curtain mechanism in the periphery of the gas exhausting mechanism.

15. The equipment for plasma treatment under the atmospheric pressure according to claim 11, wherein said vicinity of treatment section, where said plasma and said article to be treated are in contact, is maintained under the specified gas atmosphere by conducting the treatment in a vessel through which the specified gas flows.

16. The equipment for plasma treatment under the atmospheric pressure according to claim 11, wherein at least two chambers composed of chamber 1 enclosing a discharge plasma generation section and said article to be treated and chamber 2 enclosing said chamber 1 are provided, and those chambers are designed so that a gas flows out from said chamber 1 and the external air flows into said chamber 2 by making the pressure in said chamber 2 lower than the pressure in said chamber 1, and also lower than the external atmospheric pressure.

**Amended claims under Art. 19.1 PCT**

**1.** Please replace paragraphs from page 3, line 19 to page 8, line 16 with the following paragraphs.

The first aspect of the present invention provides a method for plasma treatment under the atmospheric pressure for treating an article to be treated comprising: providing a pair of opposing electrodes; introducing a treatment gas between said pair of electrodes under a pressure near the atmospheric pressure; generating plasma by applying an electric field between said electrodes; and contacting said plasma from a gas blow opening with an article to be treated, while a used gas is exhausted from an exhaust gas passage provided in a vicinity of said gas blow opening, wherein the plasma treatment is conducted under conditions wherein a conductance of a leak gas passage is smaller than a conductance of said exhaust gas passage in order to seal a treatment space, said leak gas passage being formed between said gas blow opening and article.

The second aspect of the present invention provides a method for plasma treatment under the atmospheric pressure using a remote source for treating an article to be treated comprising: providing a pair of opposing electrodes; introducing a treatment gas between said pair of electrodes under a pressure near the atmospheric pressure; generating plasma by applying an electric field between said electrodes; and contacting said plasma a from gas blow opening of an extended length with an article to be treated in a plasma treatment section, wherein the plasma treatment is conducted under conditions wherein the position of each of said remote source and article relative to the other is variable and the leak of a gas to the outside of said plasma treatment section and inflow of a gas from the outside of said plasma treatment section, each might occur through each side of said gas blow opening, said side being perpendicular to the lengthwise direction of gas blow opening.

The third aspect of the present invention provides a method for plasma treatment under the atmospheric pressure for treating an article to be treated comprising; providing a pair of opposing electrodes; introducing a treatment gas between said pair of electrodes under a pressure near the atmospheric pressure; generating plasma by applying an electric field between said electrodes; and contacting said plasma from a gas blow opening with an article to be treated, wherein at least two chambers composed of chamber 1 enclosing a discharge plasma generation section and said article to be treated and chamber 2 enclosing said chamber 1 are provided, and said two chambers are designed so that a gas flows out from said chamber 1 and the external air flows into said chamber 2 by making the pressure in said chamber 2 lower than each of the pressure in said chamber 1 and the external pressure, while introducing said treatment gas into said chamber 1.

The forth aspect of the present invention provides the method for plasma treatment under the atmospheric pressure according to one of the first to third aspects above, wherein said electric field applied between the electrodes is a pulse-like electric field having a pulse rise time and/or a pulse decay time of not longer than 10 μs, a field strength of 10 to 1,000 kV/cm and a frequency of not less than 0.5 kHz.

The fifth aspect of the present invention provides an equipment for plasma treatment under the atmospheric pressure comprising: a pair of opposing electrodes; a mechanism for introducing a treatment gas between said pair of opposing electrodes; a mechanism for applying an electric field between said electrodes; a gas blow opening from which the plasma obtained by said electric field blows out to an article to be treated; and a mechanism for exhausting an used gas from a exhaust gas passage, which is arranged so that a conductance of a leak gas passage is smaller than a conductance of said exhaust gas passage in order to seal a treatment space, said leak gas passage being formed between said gas blow opening and article.

The sixth aspect of the present invention provides the equipment for plasma treatment under the atmospheric pressure according to the sixth aspect above, wherein said gas blow opening is provided in a nozzle member having first baffle and said exhaust gas passage, so that a space in said gas blow opening is smaller than a discharge space formed between said opposing electrodes, and wherein second baffle is provided in an inlet of said exhaust gas passage, so that the pressure of plasma blows out from said nozzle member is lower than the pressure in said leak gas passage.

The seventh aspect of the present invention provides an equipment for plasma treatment under the atmospheric pressure comprising: a pair of opposing electrodes; a mechanism for introducing a treatment gas between said pair of opposing electrodes; a mechanism for applying an electric field between said electrodes; a gas blow opening of an extended length from which the plasma obtained by said electric field blows out to an article to be treated; a mechanism for exhausting an used gas; and a labyrinth seal, wherein the position of each of a remote source and a support for an article to be treated relative to the other is variable, said remote source having said gas blow opening and electrodes, and wherein an upper member of said labyrinth seal is provided in each side of said remote source, said side being perpendicular to the lengthwise direction of said remote source and a lower member of said labyrinth seal is provided on a support.

The eighth aspect of the present invention provides an equipment for plasma treatment under the atmospheric pressure comprising: a pair of opposing electrodes; a mechanism for introducing a treatment gas between said pair of opposing electrodes; a mechanism for applying an electric field between said electrodes; a gas blow opening from which the plasma obtained by said electric field blows out to an article to be treated; and a mechanism for exhausting an used gas from a exhaust gas passage, wherein at least two chambers composed of chamber 1 enclosing a discharge plasma generation section and said article to be treated and chamber 2 enclosing said chamber 1 are provided, and those chambers are designed so that a gas flows out from said chamber 1 and the external air flows into said chamber 2 by making the pressure in said chamber 2 lower than each of the pressure in said chamber 1 and the external pressure, while introducing said treatment gas into said chamber 1.

The ninth aspect of the present invention provides the equipment for plasma treatment under the atmospheric pressure according to the eighth aspect above, wherein each of said chambers 1 and 2 has an opening for carrying in/out the article to be treated.

The tenth aspect of the present invention provides the equipment for plasma treatment under the atmospheric pressure according to one of the fifth to ninth aspects above, wherein said electric field applied between the electrodes is a pulse-like electric field having a pulse rise time and/or a pulse decay time of not longer than 10 μs, a field strength of 10 to 1,000 kV/cm and a frequency of not less than 0.5 kHz.

treating an article to be treated comprising: providing a pair of opposing electrodes; introducing a treatment gas between said pair of electrodes under a pressure near the atmospheric pressure; generating plasma by applying an electric field between said electrodes; and contacting said plasma from a gas blow opening with an article to be treated, while a used gas is exhausted from an exhaust gas passage provided in a vicinity of said gas blow opening, wherein the plasma treatment is conducted under conditions wherein a conductance of a leak gas passage is smaller than a conductance of said exhaust gas passage in order to seal a treatment space, said leak gas passage being formed between said gas blow opening and article.

2. A method for plasma treatment under the atmospheric pressure using a remote source for treating an article to be treated comprising: providing a pair of opposing electrodes; introducing a treatment gas between said pair of electrodes under a pressure near the atmospheric pressure; generating plasma by applying an electric field between said electrodes; and contacting said plasma from a gas blow opening of an extended length with an article to be treated in a plasma treatment section, wherein the plasma treatment is conducted under conditions wherein the position of each of said remote source and article relative to the other is variable and the leak of a gas to the outside of said plasma treatment section and inflow of a gas from the outside of said plasma treatment section, each might occur through each side of said gas blow opening, said side being perpendicular to the lengthwise direction of gas blow opening.

3. A method for plasma treatment under the atmospheric pressure for treating an article to be treated comprising: providing a pair of opposing electrodes; introducing a treatment gas between said pair of electrodes under a pressure near the atmospheric pressure; generating plasma by applying an electric field between said electrodes; and contacting said plasma from a gas blow opening with an article to be treated, wherein at least two chambers composed of chamber 1 enclosing a discharge plasma generation section and said article to be treated and chamber 2 enclosing said chamber 1 are provided, and said two chambers are designed so that a gas flows out from said chamber 1 and the external air flows into said chamber 2 by making the pressure in said chamber 2 lower than each of the pressure in said chamber 1 and the external pressure, while introducing said treatment gas into said chamber 1.

4. The method for plasma treatment under the atmospheric pressure according to one of claims 1 to 3, wherein said electric field applied between the electrodes is a pulse-like electric field having a pulse rise time and/or a pulse decay time of not longer than 10 μs, a field strength of 10 to 1,000 kV/cm and a frequency of not less than 0.5 kHz.

5. An equipment for plasma treatment under the atmospheric pressure comprising: a pair of opposing electrodes; a mechanism for introducing a treatment gas between said pair of opposing electrodes; a mechanism for applying an electric field between said electrodes; a gas blow opening from which the plasma obtained by said electric field blows out to an article to be treated; and a mechanism for exhausting an used gas from a exhaust gas passage, which is arranged so that a conductance of a leak gas passage is smaller than a conductance of said exhaust gas passage in order to seal a treatment space, said leak gas passage being formed between said gas blow opening and article.

6. The equipment for plasma treatment under the atmospheric pressure according to claim 5, wherein said gas blow opening is provided in a nozzle member having first baffle and said exhaust gas passage, so that a space in said gas blow opening is smaller than a discharge space formed between said opposing electrodes, and wherein second baffle is provided in an inlet of said exhaust gas passage, so that the pressure of plasma blows out from said nozzle member is lower than the pressure in said leak gas passage.

**7.** An equipment for plasma treatment under the atmospheric pressure comprising: a pair of opposing electrodes; a mechanism for introducing a treatment gas between said pair of opposing electrodes; a mechanism for applying an electric field between said electrodes; a gas blow opening of an extended length from which the plasma obtained by said electric field blows out to an article to be treated; a mechanism for exhausting an used gas; and a labyrinth seal, wherein the position of each of a remote source and a support for an article to be treated relative to the other is variable, said remote source having said gas blow opening and electrodes, and wherein an upper member of said labyrinth seal is provided in each side of said remote source, said side being perpendicular to the lengthwise direction of said remote source and a lower member of said labyrinth seal is provided on a support.

**8.** An equipment for plasma treatment under the atmospheric pressure comprising: a pair of opposing electrodes; a mechanism for introducing a treatment gas between said pair of opposing electrodes; a mechanism for applying an electric field between said electrodes; a gas blow opening from which the plasma obtained by said electric field blows out to an article to be treated; and a mechanism for exhausting an used gas from a exhaust gas passage, wherein at least two chambers composed of chamber 1 enclosing said plasma opposing electrodes and said article and chamber 2 enclosing said chamber 1 are provided, and said two chambers are designed so that a gas flows out from said chamber 1 and the external air flows into said chamber 2 by making the pressure in said chamber 2 lower than each of the pressure in said chamber 1 and the external pressure, while introducing said treatment gas into said chamber 1.

**9.** The equipment for plasma treatment under the atmospheric pressure according to claim 8, wherein each of said chambers 1 and 2 has an opening for carrying in/out the article to be treated.

**10.** The equipment for plasma treatment under the atmospheric pressure according to one of claims 5 to 9, wherein said electric field applied between the electrodes is a pulse-like electric field having a pulse rise time and/or a pulse decay time of not longer than 10 μs, a field strength of 10 to 1,000 kV/cm and a frequency of not less than 0.5 kHz.

Figure 1

Wave Length

Wave Form (a)

Wave Length

Wave Form (b)

Wave Length

Wave Form (c)

Wave Length

Wave Form (d)

Figure 2

Figure 3

Figure 4

Figure 5

(a)

(b)

(c)

(d)

Figure 6

(a)

(b)

(c)

Figure 7

Figure 8

(a)

(b)

Figure 9

(a)

(b)

Side ⇦          ⇨ Side

(c)

Figure 10

Figure 11

Figure 12

(a)

(b)

Figure 13

Figure 14

Figure 15

Figure 16

EP 1 340 838 A1

## INTERNATIONAL SEARCH REPORT

| | International application No. |
|---|---|
| | PCT/JP01/09941 |

**A. CLASSIFICATION OF SUBJECT MATTER**
Int.Cl$^7$ C23C16/54, H01L21/205, H01L21/31, H01L21/302

According to International Patent Classification (IPC) or to both national classification and IPC

**B. FIELDS SEARCHED**

Minimum documentation searched (classification system followed by classification symbols)
Int.Cl$^7$ C23C16/00-56, H01L21/205, H01L21/31, H01L21/302, H05H1/46

Documentation searched other than minimum documentation to the extent that such documents are included in the fields searched
Jitsuyo Shinan Koho           1926-1996     Jitsuyo Shinan Toroku Koho  1996-2002
Kokai Jitsuyo Shinan Koho   1971-2002     Toroku Jitsuyo Shinan Koho  1994-2002

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 9-92493 A (Seiko Epson Corporation), 04 April, 1997 (04.04.1997), Par. Nos. [0015] to [0024]; Fig. 2   (Family: none) | 1,2,4~7,9, 11~15 |
| Y | | 10 |
| X | JP 7-62546 A (Shinnko Electric Co., Ltd.), 07 March, 1995 (07.03.1995), Par. Nos. [0006] to [0009]; Figs. 3, 4   (Family: none) | 1~5,7,9,11~15 |
| Y | | 10 |
| X | JP 7-166356 A (Sekisui Chemical Co., Ltd.), 27 June, 1995 (27.06.1995), Par. Nos. [0015] to [0036]; Fig. 1   (Family: none) | 1,8,11,16 |
| Y | | 10 |
| Y | JP 11-241165 A (Sekisui Chemical Co., Ltd.), 07 September, 1999 (07.09.1999), Par. Nos. [0024] to [0027]   (Family: none) | 10 |

☐ Further documents are listed in the continuation of Box C.     ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 12 February, 2002 (12.02.02) | 26 February, 2002 (26.02.02) |

| Name and mailing address of the ISA/ | Authorized officer |
|---|---|
| Japanese Patent Office | |
| Facsimile No. | Telephone No. |

Form PCT/ISA/210 (second sheet) (July 1992)